# EUROPÄISCHE PATENTSCHRIFT

(11) **EP 1 176 722 B1**
(45) Veröffentlichungstag und Bekanntmachung des Hinweises auf die Patenterteilung: **03.10.2007**
(21) Anmeldenummer: 01117230.1
(22) Anmeldetag: 16.07.2001
(51) Int. Cl.: H03K 17/945

(54) **Ultraschall-Näherungsschalter**
Ultrasonic proximity switch
Commutateur de proximité à ultrasons

(30) Priorität: 27.07.2000 DE 10036719
(43) Veröffentlichungstag der Anmeldung: 30.01.2002
(73) Patentinhaber: SIEMENS AKTIENGESELLSCHAFT, 80333 München (DE)
(72) Erfinder: Luber, Ernst, 92259 Neukirchen (DE)

(56) Entgegenhaltungen:
- EP-A- 0 520 247
- EP-B- 0 519 089
- EP-B- 0 519 090
- DE-A- 4 331 555
- DE-C- 19 822 744
- US-A- 4 715 008
- US-A- 4 779 240
- US-A- 5 895 441

## Beschreibung

Ein Ultraschall-Näherungsschalter dient zum Erfassen eines Abstands zu einem Objekt. Typisches Einsatzgebiet des Näherungsschalters ist eine Abstandsmessung, beispielsweise eine Füllstandsmessung. Oftmals werden dabei mehrere Näherungsschalter in örtlicher Nähe in einer Anlage eingesetzt.

Bei einem derartigen Betrieb von mehreren Näherungsschaltern ist deren gegenseitige Synchronisation notwendig, um sicherzustellen, dass die Signale des einen die des anderen nicht beeinflussen. Aus der EP 0 519 090 B1 ist ein Ultraschall-Näherungsschalter mit Synchronisiereinrichtung bekannt, bei dem mehrere Näherungsschalter über eine gemeinsame Leitung miteinander verbunden sind. Diese Leitung ist dabei an einem jeweiligen Freigabeanschluss der Näherungsschalter angeschlossen. Der Prozesszyklus eines Näherungsschalters setzt sich in der Regel aus einer Sendezeit (Abgabe eines Sendeimpulses) bzw. einer Erfassungszeit (Empfang eines Reflexionssignals) sowie aus einer sich daran anschließenden Auswertezeit zusammen. Da die Auswertezeiten verschiedener Näherungsschalter sich in der Regel unterscheiden, ist die Synchronisation erforderlich, um beispielsweise sicherzustellen, dass während der Erfassungszeit des ersten Näherungsschalters der zweite Näherungsschalter nicht sendet.

Zur Synchronisation weist jeder Näherungsschalter einen unter anderem für die Auswertung zuständigen Mikrocontroller auf, der - sobald er seine Auswertung vollendet hat - ein Betriebs- oder Bereitschaftssignal erzeugt, indem er durch Betätigen eines Schalters den Freigabeanschluss mit Massepotenzial verbindet. Solange einer der Näherungsschalter ein solches Betriebssignal abgibt ist die gemeinsame Synchronisationsleitung mit dem Massepotenzial verbunden. Jeder der Näherungsschalter gibt das Betriebssignal dabei nur für eine begrenzte Zeitdauer ab. Sobald sämtliche Betriebssignale beendet sind, ändert sich der Potenzialwert auf der Synchronisationsleitung. Dies wird von den einzelnen Näherungsschaltern als Initialisierungszeitpunkt für den Beginn des nächsten Prozesszyklusses ausgewertet.

Beim Einsatz des Näherungsschalters werden in Abhängigkeit des gemessenen Abstands in der Regel geeignete Maßnahmen ergriffen, um zu gewährleisten, dass beispielsweise der Füllstand sich innerhalb eines gewissen Niveaubereichs bewegt. Hierzu ist es notwendig, den Näherungsschalter auf diesen Niveaubereich zu justieren. Zur Einstellung des Niveaubereichs oder des Messabstands sind am Näherungsschalter üblicherweise mit Hilfe eines Schraubendrehers einstellbare Stellelemente vorgesehen. Die Einstellung oder Justage des Näherungsschalter mit derartigen Stellelementen erfordert ein geübtes Bedienpersonal.

Alternativ zu der Justage mit Hilfe der Stellelemente besteht bei einigen Typen von Näherungsschaltern auch die Möglichkeit der Selbstjustage. Hierbei ist ein in der Regel als Lerntaster vorgesehener Lernschalter angeordnet. Bei dessen Betätigung wird der gegenwärtige Abstand des Näherungsschalters zum Objekt erfasst und als Grenzwert abgespeichert. Dies wird in der Regel sowohl für einen oberen als auch für einen unteren Grenzwert zur Festlegung eines Messbereichs durchgeführt. Um hierbei ein versehentliches Auslösen der Selbstjustagefunktion zu verhindern, ist eine zeitliche Kodierung des Lerntasters vorgesehen. Die Selbstjustage wird beispielsweise nur dann ausgeführt, wenn der Lerntaster in einer vorgeschriebenen Abfolge oder für eine bestimmte Zeitdauer betätigt wird. Dies hat allerdings den Nachteil, dass zum Starten der Selbstjustage diese zeitliche Kodierung genau eingehalten werden muss. Andererseits bietet sie keinen sicheren Schutz gegen versehentliches und insbesondere gegen mutwilliges Betätigen des Lerntasters, mit der Folge, dass eine Dejustage erfolgt. Bei der Steuerung eines Anlagenprozesses mit Hilfe eines solchen Näherungsschalters führt dies unter Umständen zum vollständigen Stillstand der Anlage.

Aus der DE 198 22 744 C1 ist ein Verfahren zur Einstellung eines elektronischen Näherungsschalters zu entnehmen. Bei diesem wird durch Betätigung eines Tasters ein Lastanschluss des Näherungsschalters mit Massepotential verbunden. Hierdurch wird einem Mikroprozessor mitgeteilt, dass nunmehr ein Einlernprozess vorgenommen wird. Werden mehrere Näherungsschalter über einen Synchronisierungs- oder Freigabeanschluss miteinander verbunden betrieben, so wird zur Initiierung des Lernprozesses auch dieser Anschluss über den Taster mit Massepotential verbunden. Bei Betätigung des Tasters werden dann zwei Signale an den Mikroprozessor übermittelt, die ihm den Beginn des Einlernprozesses mitteilen. Der beschriebene Näherungsschalter weist daher keinen Schutz gegen versehentliches oder mutwilliges Betätigen des Tasters auf.

Aus der EP 0 519 089 B1 ist das Einlesen von Betriebsparametern in einen funktionsbereiten Näherungsschalter bekannt.

Der vorliegenden Erfindung liegt die Aufgabe zugrunde, bei einem Ultraschall-Näherungsschalter ein versehentliches oder mutwilliges Auslösen der Selbstjustagefunktion zu verhindern.

Die Aufgabe wird gemäß der Erfindung gelöst durch einen Ultraschall-Näherungsschalter mit den Merkmalen des vorliegenden unabhängigen Anspruchs 1.

Hierdurch wird die Möglichkeit geschaffen, das Auslösen der Selbstjustagefunktion auf alle Fälle zu verhindern. Selbst ein mutwilliges Betätigen des Lernschalters führt nicht zu einer Dejustage des Näherungsschalters. Insbesondere ist es von Vorteil, wenn das Sperrsignal von extern übermittelt wird. Im Umkehrschluss bedeutet dies, dass bei einer gewünschten Neujustage die Selbstjustagefunktion erst nach externer Freigabe, d.h. nach Abschalten des Sperrsignals, erfolgen kann.

Der Näherungsschalter weist einen Freigabeanschluss auf, über den ein die Betriebsbereitschaft bestimmendes Betriebssignal von der Steuerschaltung erfassbar ist, wobei das Sperrsignal über den Freigabeanschluss übermittelbar ist. Es bedarf also zur Übermittlung des Sperrsignals an den Näherungsschalter keiner weiteren externen Anschlüsse. Vielmehr wird der üblicherweise vorhandene Freigabeanschluss sowohl für das Betriebssignal als auch für das Sperrsignal verwendet. Zur Erzeugung des Betriebssignals nimmt beispielsweise der Freigabeanschluss einen hochohmigen Zustand ein. Dadurch wird der Potentialwert einer am Freigabeanschluss anliegenden Spannung beeinflusst. Das Betriebssignal ist also als ein bestimmter Potenzialwert am Freigabeanschluss anzusehen. Bei Anliegen des Betriebssignals wird das Freigabesignal erzeugt.

Vorzugsweise wird das Sperrsignal durch Anlegen einer Sperrspannung an den Freigabeanschluss erzeugt.

In vorteilhafter Weise wird die Sperrspannung an den.Freigabeanschluss über eine entsprechende Verdrahtung mit einem externen Steuergerät, insbesondere eine speicherprogrammierbare Steuerung, angelegt. Dies bietet höheren Bedienkomfort und die Möglichkeit den Näherungsschalter von einer entfernten Steuerzentrale aus anzusteuern.

Enfindungsgemäß weist die Steuerschaltung einen Mikroprozessor mit einem Lerneingang sowie mit einem Freigabeeingang auf, wobei zum Auslösen der Selbstjustagefunktion am Lerneingang ein Lernsignal und zugleich am Freigabeeingang ein Freigabesignal anliegen muss. Hierbei bestehen sowohl das Freigabesignal als auch das Lernsignal insbesondere aus bestimmten Spannungs- oder Potenzialwerten. Es müssen also zeitgleich zwei Bedingungen erfüllt werden, um die Selbstjustagefunktion zu starten. Damit bieten sich zugleich zwei Parameter, die beeinflusst werden können, um eine Auslösung der Selbstjustagefunktion mit Hilfe des Sperrsignals zu unterbinden.

Vorzugsweise ist dabei der Lerneingang als analoger Eingang ausgebildet, und die Selbstjustagefunktion ist nur in dem Fall auslösbar, wenn der Spannungswert des an den Lerneingang übermittelbaren Signals innerhalb eines vorgegebenen Spannungsbereichs liegt. Dadurch wird die Möglichkeit geschaffen, innerhalb der Steuerschaltung geeignete Spannungsteiler vorzusehen, so dass beispielsweise erst bei Betätigen des Lernschalters das an den Lerneingang übermittelte Signal innerhalb des vorgegebenen Spannungsbereichs liegt.

Vorzugsweise ist durch Betätigen des Lernschalters sowohl das Lernsignal als auch das Freigabesignal erzeugbar. Mit Betätigung des Lernschalters werden daher beide Bedingungen für die Auslösung der Selbstjustagefunktion erfüllt.

Die Erzeugung der beiden Signale, des Lernsignals sowie des Freigabesignals, beruht daher auf der Überlegung, dem Mikrocontroller geeignete Spannungs- oder Potenzialwerte zur Verfügung zu stellen. Über die Variation der Potenzialwerte an den beiden Eingängen (Lerneingang und Freigabeeingang) wird also maßgebend bestimmt, ob die Selbstjustagefunktion ausgelöst wird oder nicht. Ein wesentlicher Aspekt zur Verhinderung des Auslösens der Selbstjustagefunktion mit Hilfe des Sperrsignals ist darin zu sehen, dass durch geeignete Ausbildung der Steuerungsschaltung die an diesen beiden Eingängen anliegenden Potenzialwerte dahingehend beeinflusst werden, dass zumindest einer der Eingänge nicht aktiviert ist. Dies geschieht bevorzugt dadurch, dass der Freigabeanschluss mit einem geeigneten Potenzialwert als Sperrsignal beaufschlagbar ist, wodurch zumindest einer der Eingänge deaktiviert wird.

Hierbei ist bei Anliegen der Sperrspannung die Abgabe des Freigabesignals unterbunden.

In besonderes vorteilhafter Weise umfasst der Mikrocontroller ein Zeitglied, über das die Zeitdauer eines anliegenden Freigabesignals erfassbar ist. Dadurch wird ermöglicht, dass der Mikrocontroller in Abhängigkeit der erfassten Zeitdauer entscheidet, ob lediglich ein Betriebssignal vorliegt, oder ob das Freigabesignal durch Betätigung der Lerntaste bedingt ist. Denn da sowohl das Betriebssignal als auch die Betätigung des Lernschalters zum Erzeugen eines Freigabesignals führen, ist es von Vorteil den Unterschied zwischen diesen beiden Varianten zu erfassen. Hierbei wird ausgenutzt, dass die Zeitdauer eines Prozesszyklusses des Näherungsschalter typischerweise im Bereich von etwa 10ms liegt. Das Betriebssignal wird hierbei zweckdienlicherweise vom Mikrocontroller veranlasst, wie dies beispielsweise gemäß der EP 0 519 090 B1 vorgesehen ist. Es indiziert, dass der Näherungsschalter bereit für den nächsten Prozesszyklus ist. Die Zeitdauer des Betriebssignals liegt daher in der Regel im Bereich von einigen ms. Demgegenüber ist die Zeitdauer, die der Lernschalter geschlossen gehalten wird, viel größer. Liegt das Freigabesignal beispielsweise länger als 150ms an, so erkennt der Mikrocontroller sicher, dass der Lernschalter betätigt ist.

Erfindungsgemäß weist die Steuerschaltung einen Vergleicher auf, dem eingangsseitig einerseits ein Vergleichssignal sowie andererseits das Betriebssignal und/oder das Sperrsignal beaufschlagbar ist, wobei vom Vergleicher in Abhängigkeit der eingangsseitig beaufschlagten Spannungswerte das Freigabesignal erzeugbar ist. Das Vergleichssignal dient hierbei als Referenzsignal, um im Vergleich mit dem über den Freigabeanschluss bereitgestellten Signal zu entscheiden, ob der Freigabeeingang des Mikrocontrollers aktiviert wird oder nicht.

Bei einer Anordnung von mehreren Näherungsschaltern ist zu deren Synchronisation bevorzugt vorgesehen, diese über ihre jeweiligen Freigabeanschlüsse mittels einer gemeinsamen Synchronisationsleitung miteinander zu verbinden. Dabei sind ihre Steuerschaltungen derart ausgebildet, dass bei Verbinden der Näherungsschalter an deren Freigabeanschlüssen sich als Sperrsignal ein derartiger Potenzialwert einstellt, dass bei Betätigung eines der Lernschalter der Spannungswert am Lerneingang des Mikrocontrollers außerhalb des vorgegebenen Spannungsbereichs liegt.

Das Sperrsignal wird hierbei durch ein Verschieben des Potenzialwerts am Freigabeanschluss infolge der Verbindung der Näherungsschalter miteinander erzeugt und liegt permanent an. Bei verbundenen Näherungsschaltern ist daher die Selbstjustage unmöglich.

Dieser Ausgestaltung liegt die Idee zugrunde, die Steuerschaltungen derart auszubilden, dass bei einer Verbindung der einzelnen Näherungsschalter über die Freigabeanschlüsse die Schaltungen quasi parallelgeschaltet werden und damit die Potenzialwerte innerhalb der einzelnen Steuerschaltungen verändert werden. Und zwar werden sie dahingehend verändert, dass selbst bei Betätigen des Lernschalters der an dem Lerneingang anliegende Spannungswert außerhalb des vorgegebenen Bereichs liegt, der maßgebend für die Aktivierung des Lerneingangs ist.

Dies stellt eine zweite Variante zur Blockierung der Selbstjustagefunktion dar. Während bei der ersten durch aktives Anlegen einer Sperrspannung am Freigabeanschluss das Erzeugen des Freigabesignals verhindert wird, wird gemäß dieser zweiten Variante der Potenzialwert eher passiv dahingehend verändert, dass das Erzeugen des Lernsignals unterbunden ist.

Die im Hinblick auf den Näherungsschalter erläuterten besonderen Ausgestaltungen mit ihren Vorteilen sind sinngemäß auf das Verfahren zu übertragen.

Ausführungsbeispiele der Erfindung werden im Folgenden anhand der Zeichnung näher erläutert. Es zeigen:
- FIG 1: einen schematischen Ausschnitt aus einer beispielhaften Steuerschaltung für einen Ultraschall-Näherungsschalter,
- FIG 2: die Verbindung zweier Ultraschall-Näherungsschalter zu Synchronisationszwecken in einer schematischen Blockbilddarstellung.

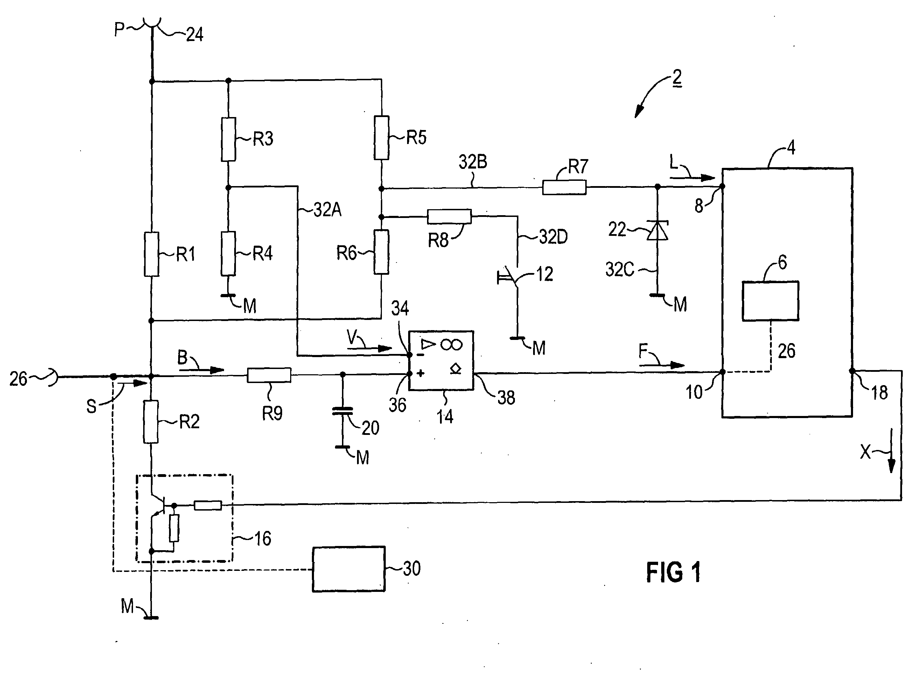

Gemäß FIG 1 umfasst eine Steuerschaltung 2 einen Mikrocontroller 4 mit einem Zeitglied 6 sowie mit einem Lerneingang 8 und einem Freigabeeingang 10, welcher mit dem Zeitglied 6 in Verbindung steht. Die Steuerschaltung 2 weist weiterhin einen als Lerntaster 12 ausgeführten Lernschalter auf sowie eine Anzahl von Widerständen R1 bis R9, einen als Vergleicher 14 ausgebildeten Operationsverstärker, und eine digitale Transistorschaltung als Schalter 16, der über einen Steuerausgang 18 des Mikrocontrollers 4 betätigbar ist. Die Steuerschaltung 2, die als weitere Bauelemente einen Kondensator 20 sowie eine Diode 22 aufweist, wird über einen Versorgungsanschluss 24 mit einer Versorgungsspannung P versorgt. Die Steuerschaltung 2 weist weiterhin einen Freigabeanschluss 26 auf.

Zur Beaufschlagung des Freigabeanschlusses 26 mit einem aktiven Sperrsignal S wird der Freigabeanschluss 26 mit dem Sperrsignal S von einem externen Steuergerät 30 beaufschlagt, beispielsweise einer speicherprogrammierbaren Steuerung.

Der Versorgungsanschluss 24 ist über den Widerstand R1 mit dem Freigabeanschluss 26 verbunden. Dieser wiederum ist über den Widerstand R2 und dem Schalter 16 mit Massenpotenzial M verbunden. Die Versorgungsspannung P vom Versorgungsanschluss 24 wird ebenfalls von den Widerständen R3 und R4 abgegriffen, die in Serie geschaltet und mit dem Massepotenzial M verbunden sind. Zwischen ihnen greift eine Leitung 32A den Spannungswert ab und beaufschlagt einen ersten Eingang 34 des Vergleichers 14 mit diesem Spannungswert als Vergleichssignal V. Parallel zum Widerstand R1 sind seriell hintereinander die Widerstände R5 und R6 angeordnet. Der Spannungswert zwischen diesen beiden Widerständen R5,R6 wird über eine weitere Leitung 32B und über den Widerstand R7 an den Lerneingang 8 übermittelt. Nach dem Widerstand R7 zweigt eine zum Massepotenzial M führende Leitung 32C mit der Diode 22 ab, die als Spannungsbegrenzer wirkt und den Lerneingang 8 vor Überspannung schützt.

Ebenfalls zwischen den Widerständen R5 und R6 zweigt eine Leitung 32D ab, in der in Serie der Widerstand R8 sowie der Lerntaster 12 angeordnet sind, welcher mit seinem einen Anschluss auf Massepotenzial M liegt.

Zwischen dem Freigabeanschluss 26 und dem Vergleicher 14 ist zu dessen Schutz ein Tiefpass geschaltet, der den Kondensator 20 sowie den Widerstand R9 umfasst.

Der Mikrocontroller 4 ist derart ausgebildet, dass er eine Selbstjustagefunktion veranlasst, sobald an seinem Lerneingang 8 und an seinem Freigabeeingang 10 ein Lernsignal L bzw. ein Freigabesignal F anliegen. Der Lerneingang 8 ist dabei als analoger Eingang ausgebildet. Er wird lediglich dann aktiviert, wenn der an ihm anliegende Spannungswert innerhalb eines definierten Spannungsbereiches liegt. Der Freigabeeingang 10 ist demgegenüber als digitaler Eingang ausgebildet. Im Ausführungsbeispiel wird er aktiviert, wenn der Spannungswert niedrig ist.

Bei der Selbstjustage wird durch Abstandsmessung der aktuelle Abstand zu einem Objekt ermittelt und als Grenzwert abgespeichert. Auf diese Weise kann ein oberer und unterer Grenzwert eines Überwachungsbereichs, beispielsweise eines Füllstandsbereich, eingegeben werden.

Neben der Ausübung der Selbstjustagefunktion ist der Mikrocontroller 4 auch für die Steuerung der Ultraschall-Signalabgabe sowie für die Auswertung der empfangenen Ultraschall-Signale ausgebildet. In der Regel wird dabei derart vorgegangen, dass das Ultraschall-Signal über eine Sendeimpulsdauer abgegeben wird. Alternativ wird während eines Erfassungszeitraums ein Ultraschall-Signal erfasst. An den Erfassungszeitraum bzw. an die Sendeimpulsdauer schließt sich eine Auswertezeit an, innerhalb derer keine Ultraschall-Signale gesendet werden. Damit wird sichergestellt, dass die Auswertung zuverlässig durchgeführt wird, und dass zugleich die Auswertung nicht durch eine zu schnelle Signalfolge gestört wird. Sendeimpulsdauer bzw. Erfassungszeitraum mit anschließender Auswertezeit bilden einen Prozesszyklus.

Nach Beendigung der Auswertung kann der nächste Prozess - oder Betriebszyklus gestartet und ein neues Ultraschall-Signal abgegeben werden. Während und/oder im Anschluss an die Auswertedauer wird von dem Mikrocontroller 4 über den Steuerausgang 18 ein Steuersignal X an den Schalter 16 übermittelt, der daraufhin schließt. Dadurch wird das am Freigabeanschluss 26 anliegende Potenzial gegen Masse M gezogen. Der dann niedrige Spannungswert bildet ein Betriebssignal B, mit dem der zweite Eingang 36 des Vergleichers 14 beaufschlagt wird. Die Steuerschaltung 2 ist dabei derart dimensioniert, dass nunmehr die am zweiten Eingang 36 anliegende Betriebsspannung kleiner ist als die am ersten Eingang 34 anliegende Spannung. Der Vergleicher 14 schaltet daher an seinem Ausgang 38 auf einen niedrigen Spannungswert und erzeugt damit das Freigabesignal F, welches an den Freigabeeingang 10 übermittelt wird. Solange das Betriebssignal B nicht am zweiten Eingang 36 anliegt, solange also ein vergleichsweise hoher Spannungswert anliegt, ist der dem ersten Eingang 34 bereitgestellte Spannungswert kleiner als die Betriebsspannung. Der Vergleicher 14 liefert dann an seinem Ausgang 38 einen hohen Signalwert. In diesem Fall liegt kein Freigabesignal F vor.

Sobald das Steuersignal X vom Mikrocontroller 4 abgebrochen wird, unterbricht der Schalter 16 die Verbindung zum Massepotenzial M und der Spannungswert am Freigabeanschluss 26 springt wieder hoch. Damit springt der Spannungswert am Ausgang 38 des Vergleichers 14 hoch, so dass nunmehr kein Freigabesignal F mehr vorliegt. Dieses Umschalten wird vom Mikrocontroller 4 als Startsignal für den nächsten Prozesszyklus gewertet.

Die Selbstjustagefunktion wird - sofern kein Sperrsignal S anliegt - durch Betätigen des Lerntasters 12 aktiviert. Durch das Schließen des Tastschalters 12 und das Zuschalten des Widerstands R8 wird der von der Leitung 32B abgegriffene Spannungswert verändert, und zwar derart, dass der am Lerneingang 8 anliegende Spannungswert nunmehr innerhalb eines vorgegebenen Bereichs liegt, welcher vom Mikroprozessor 4 als Lernsignal L gewertet wird. Gleichzeitig wird durch Schließen des Lerntasters 12 der Freigabeanschluss 26 über die Widerstände R6 und R8 mit dem Massepotenzial M verbunden. Der am Freigabeanschluss 26 anliegende Spannungswert fällt dabei unter den Spannungswert, welcher dem ersten Eingang 34 des Vergleichers 14 übermittelt wird. Es wird demnach sowohl ein Freigabesignal F als auch ein Lernsignal L erzeugt.

Gemäß einer bevorzugten Ausgestaltung wird die Zeitdauer des Anliegens des Freigabesignals F von dem Zeitglied 6 ausgewertet. Das durch das Steuersignal X bedingte Freigabesignal F liegt in der Regel nur wenige ms an und liegt unterhalb der üblichen Prozesszykluszeit von etwa 10ms bis 20ms. Demgegenüber liegt das Freigabesignal F bei Betätigen des Lerntasters 12 deutlich länger an. Somit erkennt der Mikrocontroller 4, dass der Lerntaster 12 betätigt ist, wenn das Freigabesignal F über eine bestimmte Zeitdauer, beispielsweise über 150ms, anliegt.

Um ein unbeabsichtigtes Auslösen der Selbstjustagefunktion bei Betätigung des Lerntasters 12 zu verhindern ist vorgesehen, das Sperrsignal S am Freigabeanschluss 26 anzulegen. Die Steuerschaltung 2 ist hierbei unter dem Gesichtspunkt ausgelegt, dass das Sperrsignal S die Potenzialwerte an den maßgebenden Stellen für die Erzeugung des Freigabesignals F und/oder des Lernsignals L beeinflusst. Über die spezielle Anordnung der Widerstände R1 bis R9 und des Tastschalters 12 wird hierbei insbesondere am zweiten Eingang 36 des Vergleichers 14 und/oder am Lerneingang 8 ein geeigneter Spannungswert erzeugt.

Gemäß einer ersten Variante wird das Sperrsignal S durch das aktive Anlegen einer Sperrspannung gebildet. Damit liegt das Potenzial am zweiten Eingang 36 des Vergleiches 14 sicher oberhalb des Spannungswerts am ersten Eingang 34 und ein Freigabesignal F wird nicht erzeugt. Die Betätigung des Lerntasters 12 beeinflusst den am zweiten Eingang 36 anliegenden Signalwert nicht.

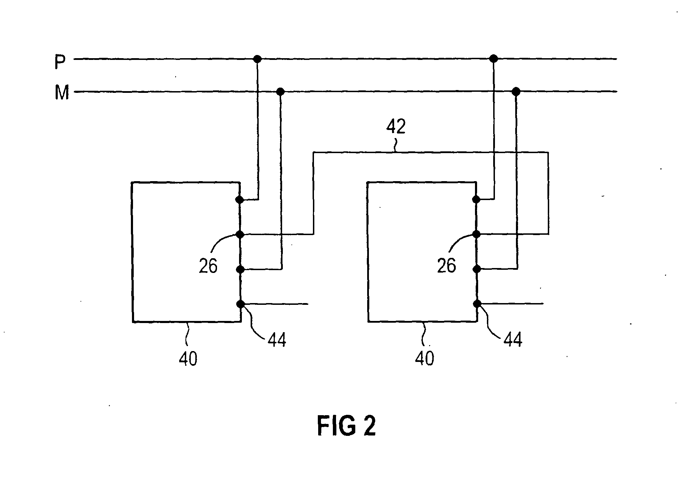

Gemäß einer zweiten Variante ist das Sperrsignal S automatisch gebildet, wenn mehrere Ultraschall-Näherungsschalter 40 über eine Synchronisationsleitung 42 zwecks Synchronisation miteinander verbunden sind, wie dies in FIG 2 dargestellt ist. Die Synchronisationsleitung 42 verbindet jeweils die Freigabeanschlüsse 26 der beiden Näherungsschalter 40 miteinander. Im Regel weisen die Näherungsschalter 40 vier Anschlüsse auf, wobei zwei dieser Anschlüsse zur Spannungsversorgung mit der Versorgungsspannung P einerseits und mit dem Massepotenzial M andererseits verbunden sind, und einer als der Freigabeanschluss 26 dient. Der vierte Anschluss ermöglicht die Verwirklichung weiterer Funktionen. Die Näherungsschalter 40 sind im Hinblick auf ihre Steuerschaltung 2 im Wesentlichen gleich aufgebaut. Durch Verbindung über die Synchronisationsleitung 42 werden diese beiden Steuerschaltungen 2 quasi parallel geschaltet. Dadurch wird der am Freigabeanschluss 26 anliegende Potenzialwert erhöht, und es verschiebt sich der zwischen den Widerständen R5 und R6 abgegriffene Spannungswert nach oben. Die Widerstände R1 und R5 bis R8 sind dabei derart dimensioniert, dass selbst bei Schließen eines der Lerntaster 12 der beiden Näherungsschalter 40 der Spannungswert am entsprechenden Lerneingang 8 nicht den notwendigen vorgegebenen Spannungsbereich erreicht, um als Lernsignal L vom Mikrocontroller 4 gewertet zu werden. Sobald also über die Synchronisationsleitung 42 mehrere Näherungsschalter 40 miteinander verbunden sind, ist ein aktivieren der Selbstjustagefunktion unmöglich gemacht. Bei dieser zweiten Variante ist das Sperrsignal S also ebenfalls durch eine geeignete Einstellung des Potenzialwerts am Freigabeanschluss 26 gebildet. Gegenüber der aktiven Beaufschlagung mit einer Spannung gemäß der ersten Variante erfolgt die Einstellung des Potenzialwerts nunmehr passiv durch Verbindung zumindest zweier Näherungsschalter 40.

Gleichzeitig ist es jedoch weiterhin möglich, über das Steuersignal X das Freigabesignal F zu erzeugen und damit dem Mikroprozessor 4 anzugeben, wenn er einen neuen Prozesszyklus starten kann. Dies ist entscheidend bei der Verbindung mehrere Näherungsschalter 40, da über dieses Initiierungssignal (Wegfall des Freigabesignals F) die Synchronisation der Näherungsschalter 40 erfolgt, wie dies beispielsweise in der EP 0 519 090 B1 beschrieben ist. Damit wird der Vorteil erzielt, dass eine versehentliche Auslösung der Selbstjustagefunktion ausgeschlossen und gleichzeitig die Synchronisation weiterhin möglich ist.

## Patentansprüche

1. Ultraschall-Näherungsschalter (40) mit einer Steuerschaltung (2), wobei die Steuerschaltung (2) aufweist:
- einen Lernschalter (12) zum Auslösen einer Selbstjustagefunktion,
- einen Mikroprozessor (4) mit einem Lerneingang (8) sowie mit einem Freigabeeingang (10), wobei zum Auslösen der Selbstjustagefunktion am Lerneingang (8) ein Lernsignal (L) und zugleich am Freigabeeingang (10) ein Freigabesignal (F) anliegen muss,
- einen Freigabeanschluss (26), über den ein die Betriebsbereitschaft bestimmendes Betriebssignal (B) von der Steuerschaltung (2) erfassbar ist, wobei die Steuerschaltung (2) über den Freigabeanschluss (26) mit einem Sperrsignal (S) beaufschlagbar ist,
- einen Vergleicher (14) zum Erzeugen des Freigabesignals (F), wobei der Vergleicher (14) an einem ersten Eingang (34) mit einem Vergleichssignal (V) sowie an einem zweiten Eingang (36) mit dem Betriebssignal (B) und dem Sperrsignal (S) beaufschlagbar ist und vom Vergleicher (14) in Abhängigkeit der eingangsseitig beaufschlagten Signalwerte das Freigabesignal (F) erzeugbar ist, wobei der Vergleicher (14) bei anliegendem Sperrsignal (S) kein Freigabesignal (F) erzeugt, und wobei bei anliegendem Sperrsignal (S) ein Betätigen des Lernschalters (12) den am zweiten Eingang (36) des Vergleichers (14) anliegenden Signalwert nicht beeinflusst, so daß selbst bei Betätigen des Lernschalters (12) ein unbeabsichtigtes Auslösen der Selbstjustagefunktion verhindert wird.

2. Näherungsschalter (40) nach Anspruch 1, bei dem das Sperrsignal (S) durch Anlegen einer Sperrspannung an den Freigabeanschluss (26) erzeugbar ist.

3. Näherungsschalter (40) nach Anspruch 2, bei dem die Sperrspannung an den Freigabeanschluss (26) über ein externes Steuergerät anlegbar ist.

4. Näherungsschalter (40) nach Anspruch 1-3, bei dem der Lerneingang (8) als analoger Eingang ausgebildet ist, und die Selbstjustagefunktion nur auslösbar ist, wenn der Spannungswert des an den Lerneingang (8) übermittelbaren Signals innerhalb eines vorgegebenen Spannungsbereichs liegt.

5. Näherungsschalter (40) nach Anspruch 1-4, bei dem durch Betätigen des Lernschalters (12) sowohl das Lernsignal (L) als auch das Freigabesignal (F) erzeugbar ist.

6. Näherungsschalter (40) nach einem der Ansprüche 1 bis 5, bei dem der Mikrocontroller (4) ein Zeitglied (6) aufweist, über das die Zeitdauer eines anliegenden Freigabesignals (F) erfassbar ist.

7. Näherungsschalter (40) nach Anspruch 1-6, bei dem das Vergleichssignal (V) einen konstanten Spannungswert aufweist.

8. Anordnung von mehreren Näherungsschalter (40) nach einem der Ansprüche 1 bis 7, die über ihre jeweiligen Freigabeanschlüsse (26) mittels einer gemeinsamen Synchronisationsleitung (42) miteinander verbunden sind, wobei ihre Steuerschaltungen (2) derart ausgebildet sind, dass bei Verbinden der Näherungsschalter (40) an deren Freigabeanschlüssen (26) sich als Sperrsignal (S) ein derartiger Spannungswert einstellt, dass bei Betätigen eines der Lernschalter (12) der Spannungswert am Lerneingang (8) außerhalb des vorgegebenen Spannungsbereichs liegt.

## Claims

1. An ultrasound proximity switch (40) with the control circuit (2) whereby the control circuit (2) features:
- a learning switch (12) to trigger a self-adjustment function,
- a microprocessor (4) with a learning input (8) and also with an enabling input (10), whereby, to trigger the self-adjustment function, there must be a learning signal (L) present at the learning input (8) and simultaneously an enabling signal (F) present at the enabling input (10),
- an enabling port (26), via which an operating signal (B) determining the operability is able to be detected by the control circuit (2), with a blocking signal (S) able to be applied to the control circuit (2) via the enabling port (26),
- a comparator (14) for creating the enabling signal (F), with a comparison signal (V) able to be applied to the comparator at a first input (34) as well as the operating signal (B) and the blocking signal at a second input (36) and the enabling signal (F) is able to be created by the comparator (14) depending on the signal values of the enabling signal (F) applied on the input side. with the comparator (14), if the blocking signal (S) is present, not creating an enabling signal (F), and whereby, if the blocking signal is present, an actuation of the learning switch (12) does not affect the signal value present at the second input (36) of the comparator (14), so that even if the learning switch (12) is actuated, an unintentional triggering of the self-adjustment function is prevented.

2. Proximity switch (40) according to claim 1, in which the blocking signal (S) is created by applying a blocking voltage to the enabling port (26).

3. The proximity switch (40) according to claim 2, in which the blocking voltage is able to be applied to the enabling port (26) via an external control unit.

4. The proximity switch (40) according to claim 1-3. in which the learning input (8) is embodied as an analogue input, and the self-adjustment function is only able to be triggered if the voltage value of the signal able to be transferred to the learning input (8) lies within a predetermined voltage range.

5. The proximity switch (40) according to claim 1-4, in which, both the learning signal (L) and also the enabling signal (F) is able to be created by actuation of the learning switch (12) .

6. The proximity switch (40) according to one of the claims 1 to 5, in which the microcontroller (4) features a timer (6) via which the duration of an existing enabling signal (F) can be detected.

7. The proximity switch (40) according to claim 1-6, in which the comparison signal has a constant voltage value (V).

8. Arrangement of a number of proximity switches (40) according to one of the claims 1 to 7, which are connected to each other via their respective enabling ports (26) by means of a common synchronization line (42), with their control circuits (2) being embodied such that, on connection of the proximity switches (40) to their enabling ports (26) a voltage value is set as a blocking signal (S) such that, on actuation of one of the learning switches (12) the voltage value at the learning input (8) lies outside the predetermined voltage range.

## Revendications

1. Commutateur (40) de proximité à ultrasons ayant un circuit (2) de commande, dans lequel le circuit (2) de commande comprend :
- un commutateur (12) d'apprentissage pour déclencher une fonction d'autoréglage,
- un microprocesseur (4) ayant une entrée (8) d'apprentissage ainsi qu'une entrée (10) de libération, dans lequel, pour déclencher la fonction d'autoréglage, il faut appliquer un signal (L) d'apprentissage à l'entrée (8) d'apprentissage et en même temps un signal (F) de libération à l'entrée (10) de libération,
- une borne (26) de libération, par laquelle un signal (B) de fonctionnement déterminant que le commutateur est prêt à fonctionner peut être détecté par le circuit (2) de commande, le circuit (2) de commande pouvant recevoir un signal (S) d'arrêt par la borne (26) de libération,
- un comparateur (14) pour la production du signal (F) de libération, le comparateur (14) pouvant recevoir un signal (V) de comparaison sur une première entrée (34) ainsi que le signal (B) de fonctionnement et le signal (S) de blocage sur le deuxième entrée (36) et le signal (F) de libération pouvant être produit par le comparateur (14) en fonction des valeurs de signal reçues côté entrée, le comparateur (14) ne produisant pas, lorsque le signal (S) de blocage est appliqué, de signal (F) de libération et, lorsque le signal (S) de blocage est appliqué, un actionnement du commutateur (12) d'apprentissage n'influe pas sur la valeur du signal appliqué à la deuxième entrée (36) du comparateur (14) de sorte que, même lorsque le commutateur (12) d'apprentissage est actionné, un déclenchement intempestif de la fonction d'autoréglage est empêché.

2. Commutateur (40) de proximité suivant la revendication 1, dans lequel le signal (S) de blocage peut être produit par application d'une tension de blocage à la borne (26) de libération.

3. Commutateur (40) de proximité suivant la revendication 2, dans lequel la tension de blocage peut être appliquée à la borne (26) de libération par un appareil extérieur de commande.

4. Commutateur (40) de proximité suivant l'une des revendications 1 à 3, dans lequel l'entrée (8) d'apprentissage est constituée sous la forme d'une entrée analogique et la fonction d'autoréglage ne peut être déclenchée que si la valeur de la tension du signal qui peut être transmis sur l'entrée (8) d'apprentissage se trouve dans une plage de tension prescrite.

5. Commutateur (40) de proximité suivant l'une des revendications 1 à 4, dans lequel tant le signal (L) d'apprentissage qu'également le signal (F) de libération peuvent être produits en actionnant le commutateur (12) d'apprentissage.

6. Commutateur (40) de proximité suivant l'une des revendications 1 à 5, dans lequel le microcontrôleur (4) comporte un élément (6) temporel par lequel la durée d'un signal (F) de libération appliqué peut être détecté.

7. Commutateur (40) de proximité suivant l'une des revendications 1 à 6, dans lequel le signal (V) de comparaison a une valeur de tension constante.

8. Agencement de plusieurs commutateurs (40) de proximité suivant l'une des revendications 1 à 7, qui sont reliés entre eux par leur borne (26) de libération respective au moyen d'une ligne (42) commune de synchronisation, leur circuit (2) de commande étant constitué de façon à ce que, lorsque les circuits (40) de proximité sont reliés, il s'établit à leur borne (26) de libération comme signal (S) de blocage une valeur de tension telle que, lorsque l'un des commutateurs (12) d'apprentissage est actionné, la valeur de la tension à l'entrée (8) d'apprentissage se trouve à l'extérieur de la plage de tension prescrite.
